# DEMANDE DE BREVET EUROPEEN

(11) **EP 1 308 786 A1**
(43) Date de publication de la demande: **07.05.2003**
(21) Numéro de dépôt: 02292699.2
(22) Date de dépôt: 30.10.2002
(51) Int. Cl.: G03F 7/20, G03B 9/40

(54) **Dispositif pour insoler une face d'un panneau**

(30) Priorité: 31.10.2001 FR 0114114
(71) Demandeur: Automa-Tech, 27100 Val de Reuil (FR)
(72) Inventeur: Vibet, Gilles M., 76140 Le Petit Quevilly (FR); Cuevas, Manuel, 76100 Rouen (FR)
(74) Mandataire: Dronne, Guy

(57) **Abrégé**

L'invention concerne un dispositif pour insoler une face (22) d'un panneau (20), en particulier d'un panneau de circuit imprimé, comprenant une source lumineuse (26). Le dispositif comprend en outre :
- deux obturateurs (16A, 16B) mobiles aptes à masquer ladite source lumineuse (26), chacun desdits obturateurs (16A, 16B) présentant un bord, lesdits bords définissant une fenêtre au travers de laquelle une zone lumineuse est générée sur ladite face (22) du panneau (20) à insoler,
- des moyens de déplacement (32) desdits obturateurs (16A, 16B) pour déplacer lesdits obturateurs (16A, 16B) dans un plan (P) disposé entre ladite source lumineuse (26) et ledit panneau (20),
- des moyens de commande (34') du déplacement desdits obturateurs (16A, 16B), de telle manière que les deux obturateurs (16A, 16B) se déplacent sensiblement à la même vitesse (V) et dans le même sens devant ladite face (22) du panneau (20).

## Description

La présente invention concerne un dispositif pour insoler au moins une face d'un panneau, en particulier d'un panneau de circuit imprimé, comprenant une source lumineuse et des moyens pour maintenir ledit panneau en regard de ladite source lumineuse.

De tels dispositifs permettent en particulier de réaliser des circuits imprimés à partir d'un panneau revêtu de matériau photosensible devant lequel on vient placer un cliché comportant les pistes à générer sur le circuit imprimé. Un faisceau lumineux permet alors d'insoler l'ensemble du panneau, par balayage successif de la surface ou bien par insolation globale de l'intégralité de la surface.

Le matériau photosensible, qui comporte généralement une encre ou un film sec, doit recevoir une quantité d'énergie lumineuse précise et constante sur toute sa surface pour assurer une bonne polymérisation du matériau photosensible garantissant la qualité finale du circuit imprimé. Lorsque le matériau est sous-exposé, son développement ultérieur se fait mal, en particulier, la polymérisation du matériau photosensible est irrégulière, conduisant souvent à des pistes sur le circuit imprimé qui sont trop fines, voire interrompues ; dans le cas contraire de la surexposition, la fidélité de la reproduction de l'image se trouve affectée, en particulier, l'élargissement des pistes au-delà de la largeur souhaitée, peut conduire à la jonction de certaines pistes entraînant des courts-circuits.

Pour accroître les gains de productivité, en particulier en diminuant le temps d'insolation total des panneaux, on cherche à employer des sources lumineuses de plus en plus fortes et des matériaux photosensibles de plus en plus sensibles. Cependant, ces sources lumineuses ne sont que quelque peu modulables, ce qui implique la nécessité de pouvoir adapter le temps d'insolation du panneau et ce dans une plage allant vers des temps toujours plus courts.

Par ailleurs, l'extinction de la source lumineuse nécessite un temps de pose long, pouvant atteindre plus de 30 minutes, avant de pouvoir rallumer la source lumineuse, qu'il est préférable d'éviter, de manière à optimiser la productivité du dispositif d'insolation. Ainsi, on prévoit généralement de laisser la source lumineuse allumée en continu et de placer un obturateur qui vient alternativement obturer et révéler la source lumineuse en se déplaçant entre elle et la face à insoler.

On connaît de tels dispositifs qui comportent un obturateur permettant alternativement de masquer ou de découvrir la source lumineuse, permettant ainsi de pouvoir laisser la source lumineuse constamment en marche.

De plus, la grande étendue de la gamme de sensibilité des matériaux photosensibles, qui peut aller de moins de 10 mJ.cm⁻² à plus de 600 mJ.cm⁻², impose une modulation importante du temps d'insolation.

Cependant, ces dispositifs à un seul obturateur ne permettent pas d'atteindre des temps d'insolation courts avec un niveau de précision de déplacement de l'obturateur suffisant et répétable.

En outre, le masquage de la source lumineuse peut se faire soit en déplaçant l'obturateur unique dans un plan, soit en le déplaçant de manière circulaire autour de la source lumineuse.

Dans le premier cas, l'obturateur plan fait généralement un aller-retour devant la source lumineuse, la zone du panneau ayant été insolée en premier l'est alors le plus longtemps, puisqu'elle est également masquée en dernier, ce qui entraîne une insolation non homogène le long de la surface.

Dans le deuxième cas, l'obturateur est généralement rotatif et nécessite un mécanisme d'entraînement en rotation qui permet d'obtenir à la fois des vitesses de rotation élevées et des arrêts rapides. Ce mécanisme permet d'insoler le panneau de manière homogène et d'adapter les temps d'insolation. Cependant, il est nécessaire d'augmenter considérablement la vitesse de rotation de l'obturateur pour obtenir des durées d'insolation très courtes, en particulier lorsqu'elles sont inférieures à la seconde, ce qui conduit à des difficultés techniques de mise en oeuvre. En effet, les contraintes dynamiques dues aux forces d'entraînement et à l'inertie du système d'entraînement, auxquelles est soumis le dispositif, sont d'autant plus importantes que la vitesse de rotation est élevée. En conséquence, pour des durées d'insolation courtes, le dispositif ne permet pas de garantir une répétabilité suffisante entre deux insolations, tant en termes de valeur des vitesses de rotation, que de précision des arrêts de l'obturateur.

L'objet de la présente invention est de fournir un dispositif qui permet d'améliorer l'insolation d'un panneau, en particulier lorsque ce dernier est recouvert d'un matériau très sensible, et qui autorise une plage des durées d'insolation importante de manière à pouvoir insoler différentes sensibilités de matériaux avec le même dispositif.

Cet objet est atteint grâce au fait que le dispositif comprend :
- un premier et un second obturateur mobiles aptes à masquer successivement et au moins en partie la source lumineuse, chacun des obturateurs présentant un bord, lesdits bords définissant une fenêtre susceptible d'être ajustée, de manière à générer au travers de la fenêtre une zone lumineuse sur la face du panneau à insoler,
- des moyens de déplacement des obturateurs pour déplacer les obturateurs dans un plan disposé entre la source lumineuse et le panneau,
- des moyens de commande du déplacement des obturateurs en fonction de la sensibilité de la face à insoler et de la puissance de ladite source lumineuse, de telle manière que les deux obturateurs se déplacent sensiblement à la même vitesse et dans le même sens devant la face du panneau.

Les sources lumineuses de forte puissance fonctionnant à des valeurs de puissance fixes, difficilement modulables, la variabilité des niveaux d'énergie se fait par l'intermédiaire des durées d'insolation différentes.

La présence des deux obturateurs permet de débuter et de terminer l'insolation dans la même zone du panneau. En déplaçant les obturateurs dans le même sens et à la même vitesse, l'homogénéité de l'insolation est garantie pour l'ensemble de la face, et ce même pour des temps très courts. De même, dans le cas du balayage, chaque zone, correspondant à la surface de la fenêtre, est soumise à la même quantité d'énergie, puisque par exemple la zone de la face qui est insolée la première est aussi la première à être masquée.

Pour des matériaux très sensibles, qui nécessitent des durées d'insolation très courtes, de l'ordre de quelques dixièmes de secondes, on choisira une fenêtre de taille inférieure à celle de la face du panneau à insoler, de manière à effectuer un balayage de l'intégralité de la face en déplaçant la fenêtre devant le panneau fixe.

A l'inverse, pour des matériaux peu sensibles, pour lesquels les durées d'insolation longues peuvent atteindre plusieurs dizaines de secondes, la fenêtre est ouverte au maximum et l'insolation est effectuée globalement sur l'intégralité de la face du panneau.

La vitesse de déplacement de chacun des obturateurs est préférentiellement constante tout au long de son déplacement devant le panneau à insoler, mais pour optimiser le temps de production, la vitesse de déplacement peut varier selon la nature du déplacement.

En effet, on comprend que pendant l'ouverture de la fenêtre d'insolation, c'est-à-dire jusqu'à ce que le premier obturateur atteigne un écartement, par rapport au second obturateur, correspondant à l'ouverture souhaitée, la vitesse de déplacement du premier obturateur peut être plus rapide que pendant l'insolation elle-même. Il s'ensuit, qu'au cours de la fermeture, la vitesse du second obturateur (identique à celle du déplacement du premier obturateur pendant l'ouverture) est aussi supérieure à la vitesse du second obturateur pendant l'insolation.

De même, le panneau peut présenter des zones d'insolation discontinues entre lesquelles les deux obturateurs peuvent être déplacés à une vitesse plus importante qu'au cours de l'insolation.

En fait, les vitesses des obturateurs peuvent varier au cours de la réalisation d'un panneau (avant, pendant, après insolation), dès lors que la vitesse de chacun des deux obturateurs est sensiblement égale l'une à l'autre pour une opération de même nature (ouverture/fermeture de la fenêtre, insolation, etc.).

Avantageusement, les moyens de déplacement peuvent permettre d'ajuster ou de moduler la vitesse de déplacement de chacun des obturateurs tout au long de leur déplacement.

Avantageusement, les moyens de déplacement comportent des premiers moyens de déplacement pour ledit premier obturateur et des seconds moyens de déplacement pour le second obturateur.

Ainsi, chaque obturateur est avantageusement relié à des moyens de déplacement qui lui sont propres de manière à pouvoir déplacer un obturateur indépendamment de l'autre. Deux modes de réalisation peuvent donc être envisagés. Dans le premier, les obturateurs sont différents l'un de l'autre et entraînés en déplacement conjointement, tandis que dans le second, les deux obturateurs sont identiques et sont entraînés individuellement par des moyens de déplacement préférentiellement identiques, mais propres à chaque obturateur.

De manière à pouvoir entraîner rapidement et avec exactitude les obturateurs devant la face du panneau à insoler, les moyens de déplacement sont des moyens précis, préférentiellement linéaires de manière à garantir une constance de la vitesse de déplacement de l'obturateur tout au long de son parcours devant le panneau à insoler.

Les moyens de déplacement comportent avantageusement un vérin, préférentiellement un vérin pneumatique sans tige.

Tous autres moyens de déplacement permettant de moduler ou d'ajuster la vitesse de déplacement des obturateurs, et ce de manière précise, fiable et répétable, peuvent être envisagés, comme un moteur linéaire par exemple.

Avantageusement, les moyens de commande comportent des premiers moyens d'initialisation du déplacement dudit premier obturateur et des seconds moyens d'initialisation du déplacement dudit second obturateur, lesdits premiers et seconds moyens d'initialisation étant indépendants les uns des autres et permettant d'ajuster la fenêtre.

Avantageusement, les moyens de commande permettent de contrôler et d'ajuster la vitesse de déplacement des obturateurs tout au long du déplacement en agissant à tout moment pendant la réalisation du panneau sur les moyens de déplacement.

L'ajustement de la taille de la fenêtre permet de moduler la quantité d'énergie reçue par les matériaux photosensibles, sans avoir à intervenir spécifiquement sur la vitesse de déplacement des deux obturateurs. Ainsi, lors de chaque changement de sensibilité du matériau photosensible ou éventuellement de la puissance de la source lumineuse, il suffit d'ajuster la taille de la fenêtre pour obtenir la quantité d'énergie souhaitée. Cet ajustement se faisant par la simple modification des paramètres de déplacement des deux obturateurs, un seul et même dispositif d'insolation permet de réaliser des circuits imprimés à partir de tous types de matériaux photosensibles.

Pour le second mode de réalisation envisagé, chaque obturateur possède des moyens d'initialisation du déplacement qui lui sont propres. Pour le premier mode de réalisation, la première variante dans laquelle l'ouverture de la fenêtre s'effectue devant la face du panneau à insoler est comparable au second mode de réalisation et impose que chaque obturateur comporte ses moyens d'initialisation propres. Dans une seconde variante, dans laquelle le positionnement du premier obturateur sur le second est réalisé préalablement à l'insolation, le déplacement des deux obturateurs se faisant à tout moment simultanément, les moyens d'initialisation sont communs et réduits à la seule initialisation du second panneau.

Avantageusement, les premiers moyens de déplacement sont disposés sur le second obturateur de sorte que le premier obturateur est apte à être mobile par rapport au second obturateur.

Ainsi, dans le premier mode de réalisation, un premier obturateur est fixé sur le second obturateur entraînant avec lui le premier. Dans ce cas, le premier obturateur présente une surface pleine qui a un rôle de masque et qui vient se placer devant le second qui comporte outre une surface pleine, une grande surface ouverte devant laquelle le premier obturateur est placé.

Le décalage entre la position du premier obturateur sur le second détermine la surface de la fenêtre. La vitesse de déplacement du premier obturateur par rapport au second importe peu, surtout lorsque la fenêtre est ouverte en dehors de la zone d'insolation préalablement au déplacement du second obturateur, et peut donc se faire par tous moyens de déplacement connus, qu'il s'agisse de moyens mécaniques, pneumatiques ou autres. Les moyens de déplacement du premier obturateur sur le second devront tout de même être choisis de manière à permettre un positionnement précis et reproductif garantissant un bon réglage de la surface de la fenêtre.

Avantageusement, le dispositif comporte en outre un dispositif de refroidissement de la source lumineuse.

La source lumineuse étant de forte puissance, jusqu'à environ 10 kW par exemple, pour des lampes à décharge à vapeur de mercure, il est souhaitable de la refroidir, par exemple, par circulation d'air froid, de manière à dissiper un maximum de chaleur et éviter de chauffer l'ensemble du dispositif d'insolation, sachant qu'au voisinage de la source lumineuse, les températures peuvent atteindre plus de 1000°C.

Lorsque l'obturateur est placé devant la source lumineuse, en particulier en position fermée, il reçoit toute l'intensité lumineuse de cette dernière. Ainsi, pour éviter toute détérioration de l'obturateur et de son voisinage (moyens de déplacement, de commande, etc.) sous l'effet de la chaleur, chaque obturateur comporte avantageusement un matériau réfractaire.

Ainsi, même en position fermée devant la source lumineuse qui est constamment allumée, l'obturateur est capable d'accumuler une quantité importante de chaleur sans être détérioré.

En outre pour préserver les obturateurs, il est préférable de réfléchir un maximum de rayons lumineux vers la source lumineuse. Ainsi, chaque obturateur présente avantageusement une surface réfléchissante qui permet de renvoyer au moins une partie de la lumière émise par la source lumineuse. Cette dernière étant préférentiellement refroidie, elle est capable d'évacuer la chaleur réfléchie par l'obturateur.

L'invention sera bien comprise et ses avantages apparaîtront mieux à la lecture de la description détaillée qui suit, de modes de réalisation représentés à titre d'exemples non limitatifs. La description se réfère aux dessins annexés sur lesquels :
- la figure 1 est une vue en perspective de l'avant du dispositif d'insolation selon l'invention,
- la figure 2 est une vue en perspective de l'arrière du dispositif d'insolation selon l'invention,
- la figure 3 est une vue en perspective des obturateurs selon un mode de réalisation, les deux obturateurs étant accolés,
- la figure 4 est une vue analogue à la figure 3 avec les deux obturateurs écartés,
- la figure 5 est une vue en perspective des obturateurs selon un autre mode de réalisation, les deux obturateurs étant accolés, et
- la figure 6 est une vue analogue à la figure 4 avec les deux obturateurs écartés.

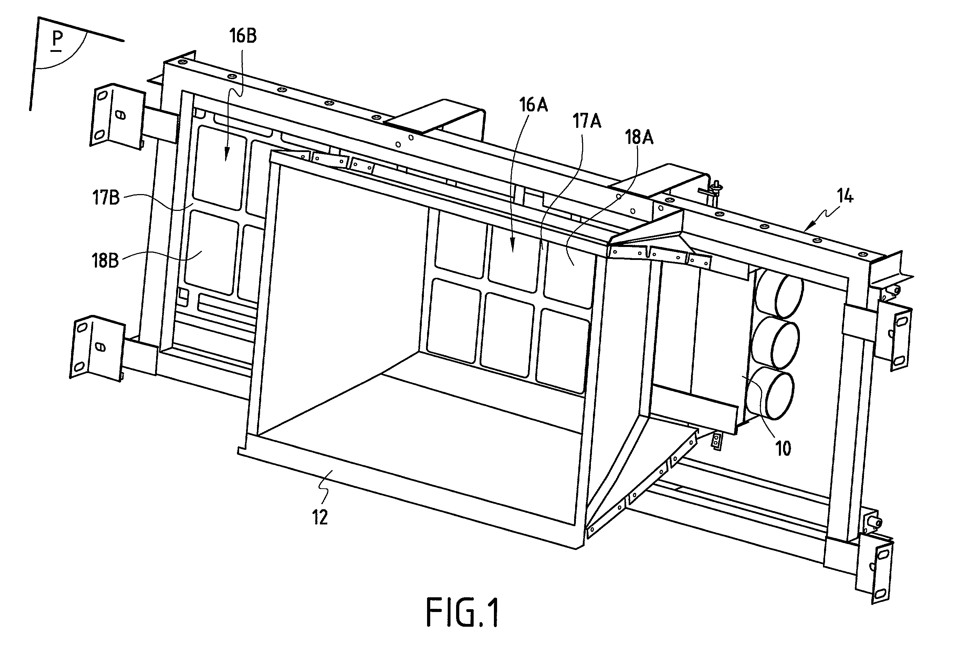

Le dispositif d'insolation selon l'invention représenté sur la figure 1, comporte un ensemble de boîte à lumière 10 et un ensemble réflecteur 12 destiné à collimater et à répartir de manière homogène la lumière émise par l'ensemble de boîte à lumière 10. L'ensemble de boîte à lumière 10 et l'ensemble réflecteur 12 sont tous deux disposés sur un cadre 14 fixé sur le bâti (non représenté) du dispositif d'insolation.

Deux obturateurs 16A et 16B sont aptes à se déplacer entre l'ensemble de boîte à lumière 10 et l'ensemble réflecteur 12 de manière à masquer et/ou découvrir l'ensemble de boîte à lumière 10 selon leur position respective. Sur la figure 1, le premier obturateur 16A est en position fermée, placé devant l'ensemble de boîte à lumière 10, tandis que le second obturateur 16B est en position d'attente sur le côté gauche du dispositif. Dans cette configuration, aucun rayon lumineux ne sort en dehors de l'ensemble de boîte à lumière 10 qui est fermé par le premier obturateur 16A. Le dispositif n'est pas en cours d'insolation.

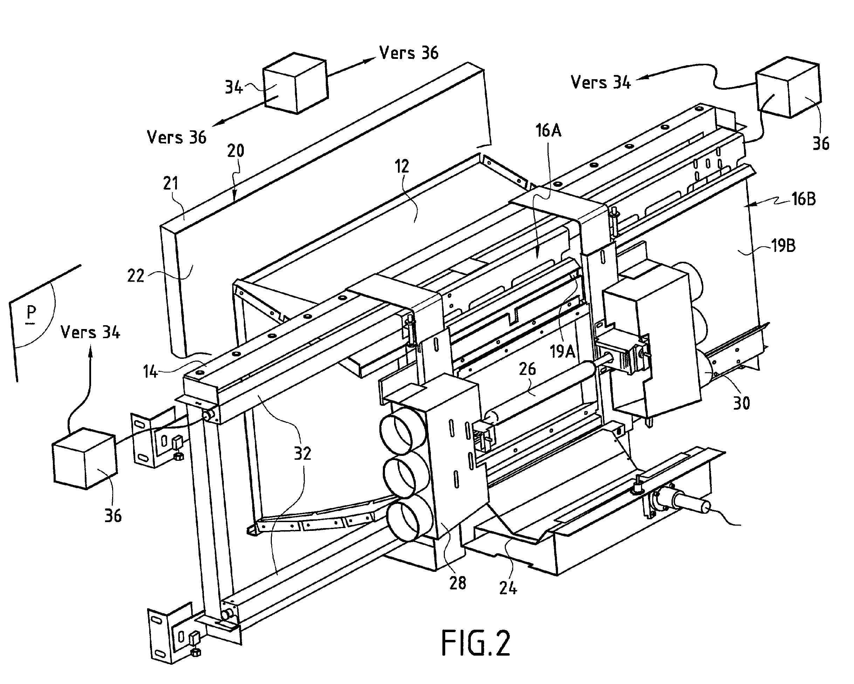

De préférence, chaque obturateur 16A, respectivement 16B, comporte une armature métallique en matériau réfractaire 17A, respectivement 17B, recouverte d'une tôle 18A, respectivement 18B, qui présente une face arrière 19A (représentée sur la figure 2), respectivement 19B, réfléchissant la lumière vers la boîte à lumière 10.

La figure 2 montre ce dispositif d'insolation vu de derrière, les deux obturateurs 16A et 16B étant dans la même position que sur la figure 1. Un panneau 20 est disposé devant l'ensemble réflecteur 12 par des moyens de maintien 21, comme un cadre coopérant avec le bâti du dispositif apte à placer la face 22 du panneau 20 en regard de l'ensemble de boîte à lumière 10 devant l'ensemble réflecteur 12.

L'ensemble de boîte à lumière 10 comporte un réflecteur supplémentaire 24 formant un couvercle arrière qui peut être ouvert, en particulier pour permettre le changement aisé des sources lumineuses, par exemple une lampe unique 26 de forme tubulaire. Un dispositif de refroidissement, par exemple, un climatiseur (non représenté), permet de refroidir l'ensemble de boîte à lumière 10 par injection d'air au travers de conduites d'arrivée d'air 28 disposées au voisinage d'un côté de l'ensemble de boîte à lumière 10. Des conduites de sortie d'air 30 disposées sur le côté opposé de l'ensemble de boîte à lumière 10 permettent d'évacuer l'air en circulation dans l'ensemble de boîte à lumière 10 et en particulier devant la source lumineuse 26 et génèrent ainsi un courant d'air permettant d'évacuer une quantité importante de chaleur.

Des moyens de déplacement 32 des obturateurs 16A et 16B coopèrent avec le cadre 14, de manière à permettre un mouvement des obturateurs 16A et 16B par rapport au cadre fixe 14 et ainsi générer un mouvement des obturateurs 16A et 16B devant l'ensemble de boîte à lumière 10 dans un plan P sensiblement parallèle au panneau 20.

Des moyens de commande de déplacement 34 reliés aux moyens de déplacement 32 permettent de commander le déplacement des obturateurs 16A et 16B à la même vitesse V, préférentiellement constante tout au long de la phase d'insolation du panneau 20 et comprise en moyenne entre 1 m.s⁻¹ et 1,5 m.s⁻¹ ; les moyens de commande de déplacement 34 comportent en outre des moyens d'initialisation 36 qui provoquent le début du déplacement de chaque obturateur.

Les moyens de déplacement 32 peuvent permettre de déplacer chacun des deux obturateurs 16A et 16B, de manière indépendante, à une vitesse V_{D} qui peut être variable, par exemple supérieure à V, pendant chacune des deux phases respectives ouverture/fermeture de la fenêtre d'insolation.

En outre, pour des raisons de réalisations particulières, il peut être préférable que la vitesse de déplacement des obturateurs 16A et 16B soit aussi variable pendant la phase d'insolation.

En fait, quelle que soit la phase considérée (ouverture/fermeture de la fenêtre, insolation, etc.), il faut que chacun des deux obturateurs 16A et 16B ait la même vitesse, non pas au même instant, mais au même point géométrique devant lequel ils passent respectivement et ce, en tout point identique, la vitesse des deux obturateurs 16A et 16B pouvant bien entendu varier au cours du temps, c'est-à-dire d'un point géométrique à l'autre.

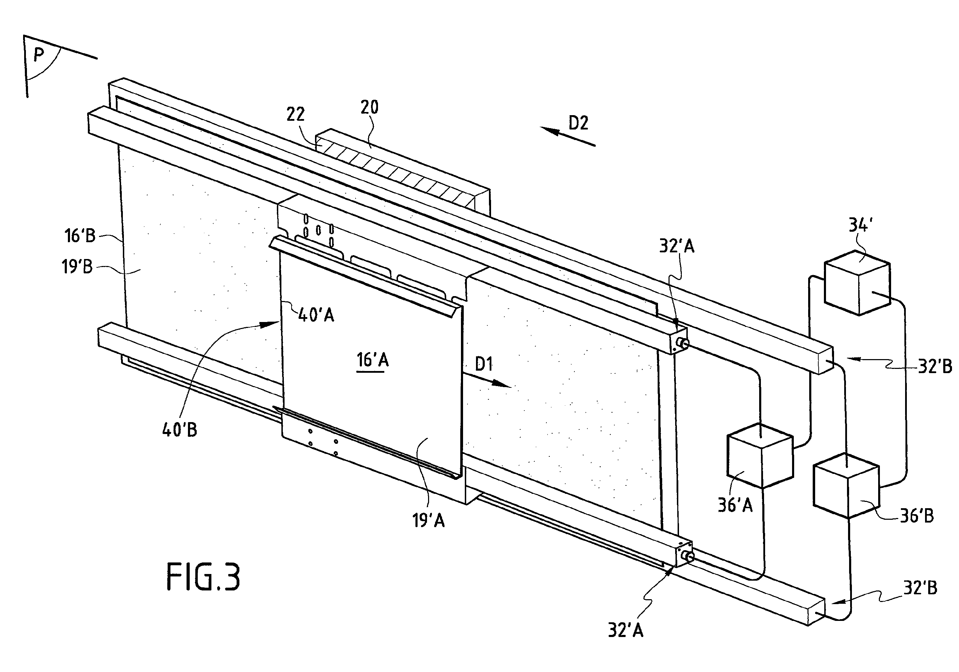

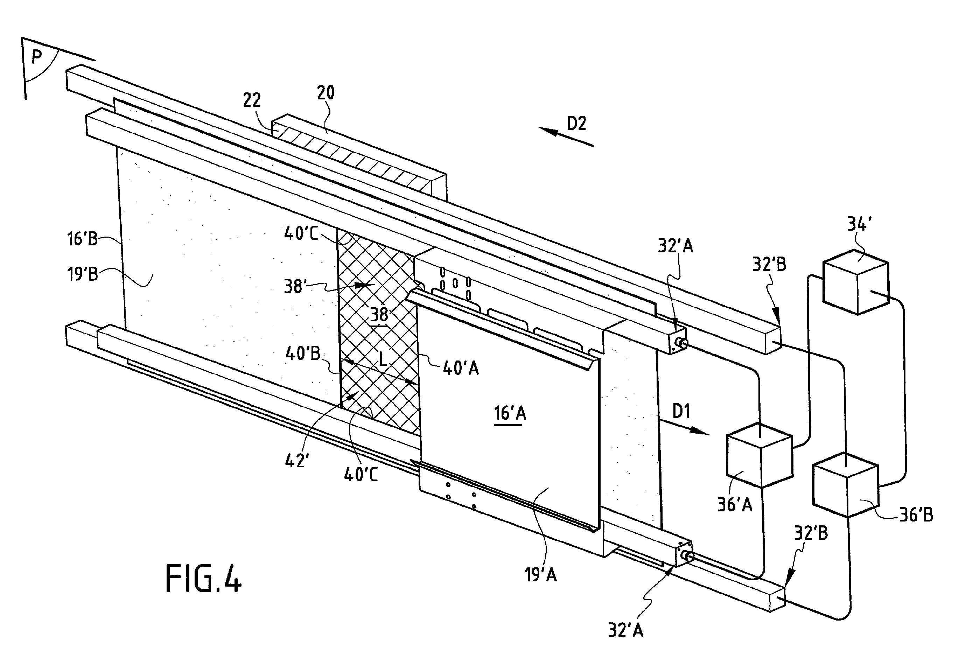

Selon un premier mode de réalisation représenté sur les figures 3 et 4, les obturateurs coulissent l'un par rapport à l'autre. En fait, un premier obturateur, par exemple 16'A coopère avec un second obturateur 16'B par l'intermédiaire de premiers moyens de déplacement comportant une glissière 32'A, une crémaillère ou tout autre moyen connu générateur de mouvement en translation préférentiellement fixé sur le second obturateur 16'B. Dans ce mode de réalisation, les moyens de déplacement comportent d'une part, pour le premier obturateur 16'A, la glissière 32'A fixée sur le second obturateur 16'B et actionnable par des premiers moyens d'initialisation 36'A qui lui sont propres, et d'autre part, pour le second obturateur 16'B, des seconds moyens de déplacement, comportant par exemple un vérin pneumatique sans tige 32'B, fixé sur le cadre 14 immobile et sur lequel l'obturateur 16'B est entraîné en translation sous l'effet des seconds moyens d'initialisation 36'B qui lui sont propres dans le plan P.

Des moyens de commande 34' sont reliés aux premiers 36'A et aux seconds 36'B moyens d'initialisation, de chaque obturateur 16'A, respectivement 16'B. Sur cette figure 3, les deux obturateurs 16'A et 16'B sont en position de fermeture, c'est-à-dire qu'aucun rayon lumineux ne traverse l'ensemble de boîte à lumière 10 (représenté sur les figures 1 et 2) pour atteindre la face 22 du panneau 20 à insoler qui est placé en regard du dispositif d'insolation.

Dans un premier temps, le premier obturateur 16'A va coulisser selon un premier sens D1 dans une direction contenue dans le plan P, sur le second obturateur 16'B de manière à ouvrir une fenêtre 38 de taille déterminée en fonction du matériau photosensible et de la puissance de la source lumineuse 26 (représentée sur la figure 2). Cette fenêtre 38 est délimitée par les bords 40'A et 40'B dans la direction du déplacement des obturateurs 16'A et 16'B et par les bords 40'C du premier obturateur 16'B dans le sens transversal ou par les moyens de support 32 ou tout autre élément du dispositif. En fait, le premier obturateur 16'B présente une ouverture 42' de dimensions comparables à celles de la face 22 du panneau 20 à insoler, de sorte que lors d'une ouverture totale de l'obturateur 16'A, l'intégralité de la face 22 puisse être insolée en un seul temps de pose.

Ainsi, selon le type de matériau photosensible de la face 22 à insoler, on choisira d'ouvrir intégralement le premier obturateur 16'A ou en partie seulement pour faire apparaître une fenêtre 38 permettant de générer une zone lumineuse 38' sur la face 22 qui, par l'intermédiaire du déplacement du second obturateur 16'B, va balayer l'intégralité de la surface. Quel que soit le type d'insolation choisi, le premier obturateur 16'A est d'abord ouvert selon l'écartement L ad hoc, par rapport au second obturateur 16'B, à une vitesse V, par exemple vers la droite de la figure 4, selon le sens D1.

Après un temps de pose, préférentiellement de l'ordre de 2 secondes, pour le cas de l'insolation globale, ou dès l'ouverture de la fenêtre 38, pour l'insolation par balayage, le second obturateur 16'B est déplacé à la même vitesse V et dans le même sens D1 que le premier obturateur 16'A, vers la droite, entraînant avec lui le premier obturateur 16'A. La portion gauche du second obturateur 16'B vient donc progressivement masquer la zone 38' qui a été insolée, au fur et à mesure de la progression de la fenêtre 38 selon le sens D1 devant la face 22.

Pour interrompre l'insolation, le second obturateur 16'B vient fermer l'ensemble de boîte à lumière 10 (représenté sur les figures 1 et 2). L'insolation suivante s'effectue ensuite de la droite vers la gauche, selon la même direction que D1 mais dans un deuxième sens D2 opposé au premier D1, et ainsi de suite.

Le premier obturateur 16'A peut être préférentiellement ouvert préalablement à la première insolation, en dehors de la zone d'insolation, sur un des côtés, de manière que le second obturateur 16'B vienne fermer l'ensemble boîte à lumière 10. Dans ce cas, la vitesse du premier obturateur 16'A permettant d'ouvrir la fenêtre 38 peut se faire à une vitesse V' différente de la vitesse de balayage V de la fenêtre 38 qui est entraînée par les deux obturateurs 16'A et 16'B.

Lorsque l'ouverture de la fenêtre 38 est réalisée hors de la zone d'insolation, c'est-à-dire en dehors de la portée de la source lumineuse 26, sur un des côtés du dispositif par exemple, le préréglage de l'ouverture de la fenêtre 38 peut être réalisé préalablement à chaque insolation.

En outre, lorsque la fenêtre peut être amenée successivement en dehors de cette zone d'insolation après chaque insolation d'un panneau 22, la fenêtre 38 peut être maintenue ouverte pendant toute la durée d'un cycle d'insolation d'une série entière de panneaux 22. Le préréglage peut alors être uniquement réalisé dans le cas de changement de la puissance de la source lumineuse 26 ou du type de matériau photosensible.

Dans ce cas de préréglage de l'ouverture de la fenêtre 38 en dehors de la zone d'insolation, la vitesse V' de déplacement du premier obturateur 16'A sur le second 16'B, peut tendre vers zéro et le premier obturateur 16'A peut être déplacé manuellement à la distance L souhaitée.

Ce préréglage de la fenêtre 38 permet de diminuer le temps total d'insolation d'une série de panneaux 22. Ce temps se trouve d'autant plus réduit, lorsque le préréglage de la fenêtre 38 est effectué en temps masqué, par exemple pendant la mise en place du premier panneau 22 à insoler ou le changement de la source lumineuse 26.

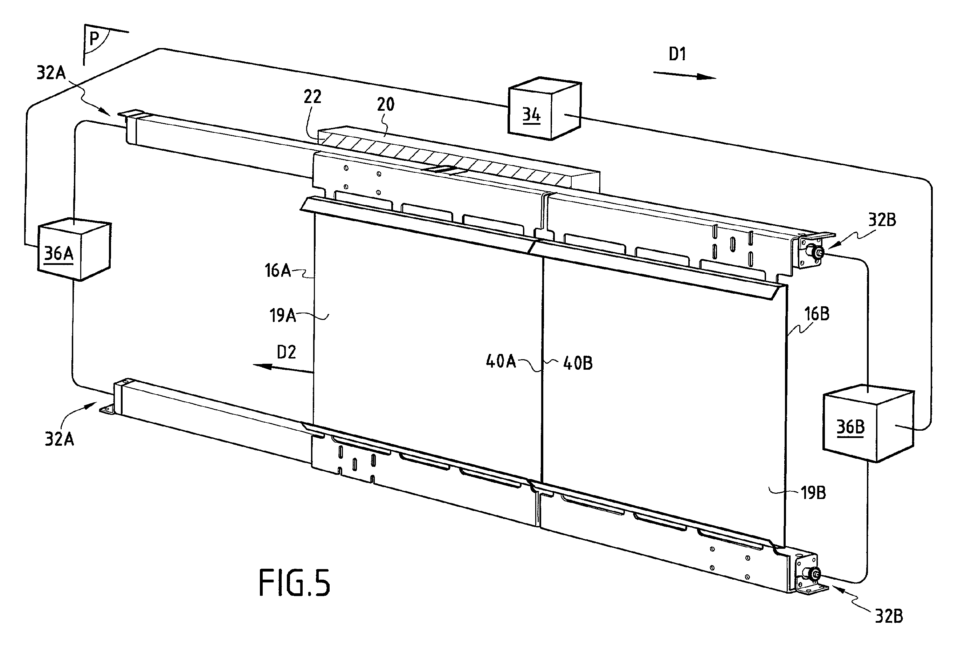

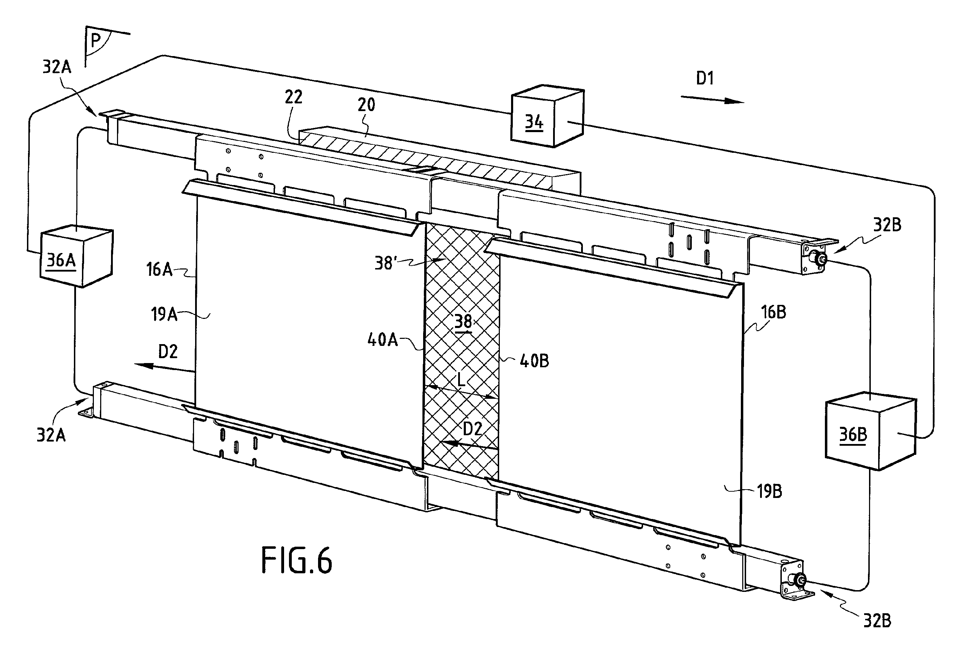

Selon un second mode de réalisation représenté sur les figures 5 et 6, les obturateurs 16A et 16B coulissent chacun individuellement devant l'ensemble de boite à lumière 10. Dans ce mode de réalisation, les deux obturateurs 16A et 16B sont identiques et se déplacent chacun nécessairement à la même vitesse V devant la source lumineuse 26 (représentée sur la figure 2). Ce mode de réalisation est comparable au mode précité et ne diffère que par le déplacement relatif des obturateurs 16A et 16B et les moyens de déplacement. Les obturateurs 16A et 16B présentent les mêmes propriétés de résistance à la chaleur d'évacuation avec une armature en matériau réfractaire (non représentée) et d'évacuation calorifique avec un côté 19A, respectivement 19B, revêtu de matériau réfléchissant la lumière.

Ainsi, en partant de la position fermée représentée sur la figure 5, dans laquelle, par exemple le premier obturateur 16A ferme l'ensemble de boîte à lumière 10 et le second obturateur 16B est sur le côté droit du dispositif, les deux bords 40A et 40B des obturateurs sont jointifs.

Chaque obturateur 16A, respectivement 16B, est fixé sur deux vérins pneumatiques sans tige 32A, respectivement 32B, disposés de part et d'autre de chaque obturateur 16A, respectivement 16B, de manière à garantir un bon guidage de chacun des obturateurs 16A et 16B. Chaque paire de vérins pneumatiques sans tige 32A, respectivement 32B, est actionnée par des moyens de commande de déplacement 34 par l'intermédiaire des premiers 36A et seconds 36B moyens d'initialisation propres à chaque paire de vérins pneumatiques sans tige 32A, respectivement 32B.

Par exemple, pour une insolation par balayage, la fenêtre 38 est partiellement ouverte par l'intermédiaire des premiers moyens d'initialisation 36A du premier obturateur 16A qui activent le déplacement de ce dernier à la vitesse V, vers la gauche, soit selon le sens D2, comme représenté sur la figure 6, tout en gardant le second obturateur 16B immobile.

Dès l'ouverture à la taille souhaitée de la fenêtre 38, soit en ayant atteint un déplacement du premier obturateur de L entre les deux bords 40A et 40B, on actionne le déplacement du second obturateur 16B à l'aide des seconds moyens d'initialisation 36B, qui se met à suivre le premier obturateur 16A à la même vitesse V et dans le même sens D2. La fenêtre 38 de taille fixe, correspondant à l'écartement des deux obturateurs 16A et 16B mobiles à la même vitesse V, se trouve ainsi en déplacement, selon le sens D2, devant l'ensemble de boîte à lumière 10 (représenté sur les figures 1 et 2) et devant la face 22 à insoler, à la vitesse V.

En bout de course, correspondant généralement à environ 50 cm, la fenêtre 38 se referme en rapprochant le bord 40B du second obturateur 16B du bord 40A du premier obturateur 16A à son tour immobilisé.

L'insolation suivante s'effectue en déplaçant les obturateurs 16A et 16B de la même manière que celle précitée, en repartant vers la droite, selon le sens D1, et ainsi de suite.

Pour réaliser une l'insolation globale de la face 22, après avoir ouvert la fenêtre 38 à son maximum en déplaçant le premier obturateur 16A vers la gauche, selon le sens D2, à la vitesse V, un temps de pose, préférentiellement de l'ordre de 2 secondes est respecté, pendant lequel les deux obturateurs 16A et 16B sont immobiles. Passé ce temps, le second obturateur 16B entame son déplacement vers la gauche, toujours selon le sens D2 et à la vitesse V jusqu'à refermer la fenêtre 38 lorsque son bord 40B vient au contact du bord 40A, et ainsi de suite.

Quel que soit le type d'insolation retenu, par balayage en déplaçant la fenêtre 38 ou global en ouvrant au maximum la fenêtre 38, cette dernière peut être maintenue ouverte à la fin de l'insolation de la face 22. Dans ce cas, il suffit de déplacer la fenêtre 38 au-delà de la zone d'insolation, soit alternativement, sur le côté gauche et sur le côté droit du dispositif.

Le mode de fonctionnement par balayage de la face 22 à insoler, ce qui revient à déplacer la fenêtre 38, est particulièrement recommandé lorsque les durées d'insolation sont inférieures à la seconde, tandis que l'insolation globale est plus adaptée aux durées d'insolation pouvant atteindre plusieurs secondes.

L'objectif de la présente invention est de permettre d'insoler l'intégralité de la face 22 par balayage ou insolation globale, mais il est bien entendu que ce dispositif permet aussi l'insolation de zones délimitées sur la face 22, par exemple une bande ou toute autre forme plus complexe. Pour cela, il suffit de prévoir, par exemple, des obturateurs ou des fenêtres mobiles selon d'autres directions ou des obturateurs de formes plus élaborées.

## Revendications

1. Dispositif pour insoler au moins une face (22) d'un panneau (20), en particulier d'un panneau de circuit imprimé, comprenant une source lumineuse (26) et des moyens pour maintenir (21) ledit panneau (20) en regard de ladite source lumineuse (26), **caractérisé en ce qu'**il comprend en outre :
- un premier et un second obturateur (16A, 16B ; 16'A, 16'B) mobiles aptes à masquer successivement et au moins en partie ladite source lumineuse (26), chacun desdits obturateurs (16A, 16B ; 16'A, 16'B) présentant un bord (40A, 40B ; 40'A, 40'B, 40'C), lesdits bords (40A, 40B ; 40'A, 40'B, 40'C) définissant une fenêtre (38) susceptible d'être ajustée, de manière à générer au travers de ladite fenêtre (38) une zone lumineuse (38') sur ladite face (22) du panneau (20) à insoler,
- des moyens de déplacement (32 ; 32A, 32B ; 32'A, 32'B) desdits obturateurs (16A, 16B ; 16'A, 16'B) pour déplacer lesdits obturateurs (16A, 16B ; 16'A, 16'B) dans un plan (P) disposé entre ladite source lumineuse (26) et ledit panneau (20),
- des moyens de commande (34 ; 34') du déplacement desdits obturateurs (16A, 16B ; 16'A, 16'B) en fonction de la sensibilité de la face (22) à insoler et de la puissance de ladite source lumineuse, de telle manière que les deux obturateurs (16A, 16B ; 16'A, 16'B) se déplacent sensiblement à la même vitesse (V) et dans le même sens (D1, D2) devant ladite face (22) du panneau (20).

2. Dispositif selon la revendication 1, **caractérisé en ce que** lesdits moyens de déplacement (32 ; 32A, 32B ; 32'A, 32'B) comportent des premiers moyens de déplacement (32A; 32'A) pour ledit premier obturateur (16A ; 16'A) et des seconds moyens de déplacement (32B ; 32'B) pour le second obturateur (16B ; 16'B).

3. Dispositif selon l'une quelconque des revendications précédentes, **caractérisé en ce que** lesdits moyens de déplacement comportent un vérin (32B ; 32'A, 32'B).

4. Dispositif selon l'une quelconque des revendications précédentes, **caractérisé en ce que** lesdits moyens de commande (34 ; 34') comportent des premiers moyens d'initialisation (36A ; 36'A) du déplacement dudit premier obturateur (16A ; 16'A) et des seconds moyens d'initialisation (36B ; 36'B) du déplacement dudit second obturateur (16B ; 16'B), lesdits premiers (36A ; 36'A) et seconds (36B ; 36'B) moyens d'initialisation étant indépendants les uns des autres et permettant d'ajuster ladite fenêtre (38).

5. Dispositif selon l'une quelconque des revendications 2 à 4, caractérisé en ce lesdits premiers moyens de déplacement (32A) sont disposés sur ledit second obturateur (16B) de sorte que ledit premier obturateur (16A) est apte à être mobile par rapport au second obturateur (16B).

6. Dispositif selon l'une quelconque des revendications précédentes, **caractérisé en ce qu'**il comporte en outre un dispositif de refroidissement (28, 30) de ladite source lumineuse (26).

7. Dispositif selon l'une quelconque des revendications précédentes, **caractérisé en ce que** chaque obturateur (16A, 16B ; 16'A, 16'B) comporte un matériau réfractaire (17A, 17B).

8. Dispositif selon l'une quelconque des revendications précédentes, **caractérisé en ce que** chaque obturateur (16A, 16B ; 16'A, 16'B) présente une surface (19A, 19B) réfléchissante qui permet de réfléchir au moins une partie de la lumière émise par la source lumineuse (26).
